(19) Europäisches Patentamt
European Patent Office
Office européen des brevets

(11) **EP 1 520 872 A1**

(12) **EUROPÄISCHE PATENTANMELDUNG**

(43) Veröffentlichungstag:
**06.04.2005 Patentblatt 2005/14**

(21) Anmeldenummer: **04022020.4**

(22) Anmeldetag: **16.09.2004**

(51) Int Cl.[7]: **C08J 5/18**, C08K 3/22, C08L 67/02, C23C 18/16, H05K 3/18

(84) Benannte Vertragsstaaten:
**AT BE BG CH CY CZ DE DK EE ES FI FR GB GR HU IE IT LI LU MC NL PL PT RO SE SI SK TR**
Benannte Erstreckungsstaaten:
**AL HR LT LV MK**

(30) Priorität: **24.09.2003 DE 10344512**

(71) Anmelder: **Mitsubishi Polyester Film GmbH**
**65203 Wiesbaden (DE)**

(72) Erfinder:
- **Kliesch, Holger, Dr.**
  **55252 Mainz (DE)**
- **Kiehne, Thorsten, Dr.**
  **65185 Wiesbaden (DE)**
- **Hilkert, Gottfried, Dr.**
  **55291 Saulheim (DE)**
- **Kuhmann, Bodo**
  **65594 Runkel (DE)**

(74) Vertreter: **Schweitzer, Klaus, Dr. et al**
**Patentanwaltskanzlei Zounek,**
**Industriepark Kalle-Albert,**
**Gebäude H391**
**Rheingaustrasse 190-196**
**65174 Wiesbaden (DE)**

(54) **Einschichtige, orientierte, mittels elektromagnetischer Strahlung strukturierbare Folie aus thermoplastischem Polyester zur Herstellung selektiv metallisierter Folien**

(57) Die Erfindung betrifft eine einschichtige, orientierte Folie aus einem Polyester, der ein Additiv enthält, welches unter Bestrahlung mit elektromagnetischer Strahlung Metallkeime bildet, an denen sich in weiteren Prozessschritten weiteres Metall anlagern lässt. Die Erfindung betrifft ferner ein Verfahren zur Herstellung dieser Folie und ihre Verwendung in Leiterplatten, Flachbandkabeln, Smartcards, RFID-Labels, Folientastaturen und folienbasierten Schaltungen aller Art.

EP 1 520 872 A1

## Beschreibung

Einschichtige, orientierte, mittels elektromagnetischer Strahlung strukturierbare Folie aus thermoplastischem Polyester zur Herstellung selektiv metallisierter Folien

Die Erfindung betrifft eine einschichtige, orientierte Folie aus einem Polyester, der ein Additiv enthält, welches unter Bestrahlung mit elektromagnetischer Strahlung Metallkeime bildet, an denen sich in weiteren Prozessschritten weiteres Metall anlagern lässt. Die Erfindung betrifft ferner ein Verfahren zur Herstellung dieser Folie und ihre Verwendung in Leiterplatten, Flachbandkabeln, Smartcards, RFID-Labels, Folientastaturen und folienbasierten Schaltungen aller Art.

Die Verwendung von Polyesterfolien für Elektroisolieranwendungen ist Stand der Technik. Die immer höheren Anforderungen hinsichtlich Komplexität der Schaltungen auf kleinem Raum sowie die Notwendigkeit solche Schaltungen schnell, flexibel und kostengünstig produzieren zu können, stellt hohe technologische Anforderungen an die Folie und die Weiterverarbeitungsschritte.

Konventionelle Verfahren zur Herstellung flexibler Schaltungen betreffen meist die vollflächige Metallisierung der Folienbahn oder Kaschierung der Folienbahn mit Metallfolie und anschließendes Strukturieren der so entstandenen leitfähigen Flächen mit verschiedenen Verfahren, z.B. Ätzen oder mechanisches Entfernen der unerwünschten Metallmengen. Oder aber Verfahren, bei denen das Metall aufgeprägt/aufgedruckt wird, oder eine Leitpaste aus Kohle/Silber aufgetragen wird. Nachteile dieser Verfahren liegen in der geringen Flexibilität und Präzision solcher Verfahren, welche einen größeren Abstand der Leiterbahnen untereinander bedingt und/oder der hohen mit diesen Verfahren verbundenen Kosten und/oder der niedrigen Produktionsgeschwindigkeiten.

In der EP-A-1 274 288 wird ein Verfahren beschrieben, bei dem aus kupferhaltigen Metalloxiden durch Laserbestrahlung Kupferkeime gebildet werden, an denen in einem anschließenden Galvanisierungsschritt weiteres Kupfer abgeschieden wird. In dieser Druckschrift werden ausschließlich Spritzgussteile beschrieben, und es fehlen Hinweise, wie und ob das Verfahren für Polyesterfolien und Folien im Allgemeinen angewendet werden kann. Insbesondere fehlen Hinweise, wie die Rohstoffe und Additive beschaffen sein müssen, um daraus orientierte Folien herstellen zu können. Das in EP-A-1 274 288 beschriebene PBT/$SiO_2$/Spinell-Compound ist zur Herstellung orientierter Folien ungeeignet, da das verwendetete Polybutylenterephthalat aufgrund seiner hohen Kristallisationsgeschwindigkeit und des hohen Füllgrads mit pyrogener Kieselsäure nicht verfahrenssicher verarbeitbar ist.

Insbesondere fehlen Hinweise wie eine Folie mit hinreichender Dimensionsstabilität bei lokaler Erwärmung nach Bestrahlung mit elektromagnetischer Strahlung und Weiterverarbeitung hergestellt werden kann.

Aufgabe der vorliegenden Erfindung war es, eine Folie bereitzustellen, welche die genannten Nachteile nicht aufweist und die eine strahlungsaktivierbare Verbindung enthält, die Metallkeime bildet, an denen sich in weiteren Verfahrensschritten weiteres Metall anlagern lässt. Weiterhin sollte eine solche Folie neben einer wirtschaftlichen Herstellung und einer guten Verstreckbarkeit, gute mechanische Eigenschaften, das bedeutet eine hohe Reißfestigkeit in Längs- und Querrichtung, einen hohen E-Modul in Längs- und Querrichtung, eine hohe Reißdehnung in Längs- und Querrichtung und eine hohe Zugspannung zur Erzeugung einer Dehnung von 5 % (F5-Wert) in Längsund Querrichtung aufweisen sowie einen definierten Schrumpf aufweisen.

Gelöst wird diese Aufgabe durch eine einschichtige, mindestens uniaxial gestreckte Polyester-Folie mit einer Dicke von 5 - 500 µm (bevorzugt 12 - 200 µm und besonders bevorzugt 30 - 150 µm), die bevorzugt 0,1 - 15 Gew.-% (bevorzugt 1,0 - 10 Gew.-% und besonders bevorzugt 2,0 - 8,0 Gew.-%) - bezogen auf die Folie - einer durch elektromagnetische Strahlung aktivierbaren Metallverbindung enthält.

Unter einer strahlungsaktivierbaren Verbindung ist eine metallhaltige (anorganische oder organische) Verbindung zu verstehen, die infolge einer Absorption von elektromagnetischer Strahlung in einer chemischen Reaktion Metall in elementarer Form freisetzt. Diese chemische Reaktion kann auch unter Beteiligung weiterer Reaktionspartner erfolgen. Weiterhin ist es möglich, dass die elektromagnetische Strahlung nicht direkt von der metallhaltigen Verbindung absorbiert wird, sondern durch andere Substanzen, die anschließend die absorbierte Energie auf die metallhaltige Verbindung übertragen und so die Freisetzung von elementarem Metall bewirken. Bei der elektromagnetischen Strahlung kann es sich um UV-Licht (Wellenlänge 100 - 400 nm), sichtbares Licht (Wellenlänge 400 - 800 nm) oder Infrarotlicht (Wellenlänge 800 - 25000 nm) handeln, wobei die Verwendung von Infrarotlicht bevorzugt ist. Weitere bevorzugte Strahlungsformen sind Röntgen-, Gamma- und Partikelstrahlung (Elektronen-, $\alpha$- und $\beta$-Strahlung).

Die Anlagerung von weiterem Metall an die durch elektromagnetische Strahlung erzeugten Metallkeime erfolgt bevorzugt durch galvanische (nasschemische) Verfahren.

Zu einer guten Verstreckbarkeit zählt, dass sich die Folie bei ihrer Herstellung hervorragend uniaxial oder biaxial ohne Abrisse orientieren lässt.

Zu den guten mechanischen Eigenschaften zählen unter anderem ein hoher E-Modul in mindestens einer Folienrichtung (Längsrichtung (MD) und/oder Querrichtung (TD)) von größer als 500 $N/mm^2$, bevorzugt größer als 2000 $N/mm^2$ und besonders bevorzugt von größer als 4000 $N/mm^2$, sowie hohe Reißfestigkeitswerte in mindestens einer Folienrichtung (Längsrichtung (MD) und/oder Querrichtung (TD)) von größer als 50 $N/mm^2$, bevorzugt größer

als 100 N/mm² und besonders bevorzugt von größer als 150 N/mm², hohe Reißdehnungswerte in mindestens einer Folienrichtung (Längsrichtung (MD) und/oder Querrichtung (TD)) von größer als 10 % bevorzugt größer als 40 % und besonders bevorzugt von größer als 80 %.

Die einer bevorzugten Ausführungsform weist die erfindungsgemäße Folie in keiner Folienrichtung (weder in MD noch in TD) einen Schrumpf bei 200 °C von größer 25 % auf. Der Schrumpf bei 200 °C ist bevorzugt sogar kleiner als 15 % und besonders bevorzugt kleiner als 5 %.

Die erfindungsgemäße Folie enthält als Hauptpolymerbestandteil (d.h. zu 55-100 Gew.-%, bevorzugt 70-100 Gew.% und besonders bevorzugt 90 - 100 Gew.-%) einen Polyester.

Erfindungsgemäß versteht man unter einem Polyester

- Homopolyester,
- Copolyester,
- Blends verschiedener Polyester,

wobei diese sowohl als reine Rohstoffe, als auch als Rezyklat enthaltende Polyester-Rohstoffe eingesetzt werden können.

Polyester enthalten Wiederholungseinheiten, die sich von Dicarbonsäuren (100 Mol-%) und Diolen (ebenfalls 100 Mol-%) ableiten. Die erfindungsgemäßen Polyester basieren bevorzugt auf Terephthalsäure oder 2,6-Naphthalindicarbonsäure als Dicarbonsäure und auf Ethylenglykol als Diol.

Insbesondere enthalten die erfindungsgemäßen Polyester 10 - 100 Mol-% Terephthalat oder 10 -100 Mol-% 2,6-Naphthalat als Dicarbonsäurekomponeneten (wobei die Gesamtmenge an Dicarbonsäurekomponeten 100 Mol-% ausmachen). Als weitere Dicarbonsäurekomponeneten kann der erfindungsgemäße Polyester 0-50 Mol-% 2,6-Naphthalat (wenn als Hauptkomponente Terephthalat eingesetzt wurde), 0 - 50 Mol-% Terephthalat (wenn als Hauptkomponente Naphthalat verwendet wurde), 0 - 20 Mol-% Isophthalat (bevorzugt 0,5 - 4 Mol-%) sowie 10-60 Mol-% 4,4'-Diphenyldicarboxylat enthalten. Andere Dicarbonsäurekomponeneten wie 1,5-Naphthalindicarboxylat sollten einen Anteil von 30 Mol-%, bevorzugt 10 Mol-%, insbesondere 2 Mol-%, nicht überschreiten.

Als Diolkomponente enthält der erfindungsgemäße Polyester 10- 100 Mol-% Ethylenglykol (EG) (wobei die Gesamtmenge an Diolkomponenten 100 Mol-% ausmachen).

Der Anteil an Diethylenglykol sollte 10 Mol% nicht überschreiten und liegt idealerweise zwischen 0,5 und 5 Mol-%. Andere Diolkomponenten wie Cyclohexandimethanol, 1,3-Propandiol, 1,4-Butandiol sollten einen Anteil von 50 Mol-% nicht überschreiten und liegen bevorzugt bei einem Anteil von weniger als 30 Mol-%, besonders bevorzugt bei weniger als 10 Mol-%.

Neben den genannten Hauptpolymerbestandteilen kann die Folie in weiteren Ausführungsformen bis zu 45 Gew.-% (bevorzugt bis zu 30 Gew.-%, besonders bevorzugt bis zu 20 Gew.-%, bezogen auf die Masse der Folie) andere Polymere wie Polyetherimide (z.B. ®Ultem 1000 von GE Plastics Europe, NL), Polycarbonat (z.B. ®Makrolon von Bayer, DE), Polyolefine wie COCs (z.B. ®Topas von Ticona, DE), Polyamide (®Ultramid von BASF, DE) u.a. enthalten.

Allgemein werden die Polyester nach literaturbekannten Verfahren aus den genannten Diolen und Dicarbonsäure oder Dicarbonsäureester hergestellt. Die Herstellung der Polyester kann sowohl nach dem Umesterungsverfahren mit den üblichen Katalysatoren wie z.B. Zn-, Ca-, Li- und Mn-Salzen oder nach dem Direktveresterungsverfahren erfolgen.

Die strahlungsaktivierbare Verbindung besteht aus elektrisch nichtleitenden thermisch hochstabilen organischen oder anorganischen Metallverbindungen, die bevorzugt in wässrigen sauren oder alkalischen Metallisierungsbädern beständig und nicht löslich sind. Besonders geeignet sind solche Verbindungen, die Licht, insbesondere im IR-Bereich möglichst vollständig absorbieren. Solche Verbindungen sind in EP-A-1 274 288 beschrieben. Bevorzugt sind hierbei Verbindungen von Metallen der d- und f-Gruppe des Periodischen Systems mit Nichtmetallen. Besonders bevorzugt handelt es sich bei den metallhaltigen Verbindungen um Metalloxide, insbesondere um Monoxide der d-Metalle des Periodischen Systems. Besonders geeignet sind höhere Metalloxide. Gemäss einer besonders bevorzugten Ausführungsform der Erfindung sind die höheren Oxide Spinelle, insbesondere kupferhaltige Spinelle wie $CuCr_2O_4$. Geeignete kupferhaltige Spinelle sind kommerziell erhältlich, so z.B. der Typ PK 3095 der Fa. Ferro (DE) oder die Typen 34E23 oder 34E30 der Firma Johnson Matthey (DE).

Die erfindungsgemäße Folie enthält diese Verbindungen in einer Konzentration von 0,1 - 15 Gew.-%, bevorzugt 1,0 - 10 Gew.-% und besonders bevorzugt 2,0 - 8,0 Gew.-%.

Sofern die metallhaltige Verbindung in dem zur Folienherstellung verwendeten Polyester nicht löslich ist, handelt es sich um Partikel mit einer mittleren Größe ($d_{50}$-Wert) von 0,01 - 20 µm, bevorzugt 0,05 - 10 µm und besonders bevorzugt 0,1-5 µm.

Neben der strahlungsaktivierbaren Verbindung kann die erfindungsgemäße Folie weitere partikuläre Additive wie Füllstoffe und Antiblockmittel enthalten. Typische Füllstoffe und Antiblockmittel sind anorganische und/oder organische Partikel, beispielsweise Siliciumdioxid (natürlich, gefällt oder pyrogen), Calciumcarbonat, Magnesiumcarbonat, Bariumcarbonat, Calciumsulfat, Bariumsulfat, Lithiumphosphat, Calciumphosphat, Magnesiumphosphat, Titandioxid (Rutil oder Anatas), Kaolin (hydratisiert oder calciniert), Aluminiumoxid, Aluminiumsilikate, Lithiumfluorid, Calcium-, Barium-, Zink- oder Mangansalze der eingesetzten Dicarbonsäuren oder vernetzte Polymerpartikel, z.B. Polystyrol oder Polymethylmethacrylatpartikel.

Es können auch Mischungen von zwei oder mehreren der oben genannten Partikelsysteme oder Mischungen von Partikelsystemen mit gleicher chemischer Zusammensetzung, aber unterschiedlicher Partikelgröße gewählt werden. Die Partikel werden dem Polyester zweckmäßigerweise schon vor dem Aufschmelzen zugesetzt.

Sofern neben der strahlungsaktivierbaren Verbindung weitere partikuläre Additive in der Folie enthalten sind, beträgt die Gesamtkonzentration dieser Partikel weniger als 20 Gew.-% bezogen auf das Gesamtgewicht der Folie, bevorzugt weniger als 15 Gew.-% und besonders bevorzugt weniger als 5 Gew.-%. Die partikulären Additive haben eine mittlere Größe ($d_{50}$-Wert) von 0,01 - 15 µm, bevorzugt 0,03 - 10 µm und besonders bevorzugt 0,05 - 1 µm. In einer bevorzugten Ausführungsform liegt der Anteil von Partikeln mit einem $d_{50}$ > 3 µm bei kleiner 2000 ppm und besonders bevorzugt bei < 1000 ppm.

Es hat sich gezeigt, dass auch Folien ohne weitere partikuläre Additive (außer der strahlungsaktivierbaren Metallkomponente) gemäß der Erfindung eingesetzt werden können. Die Bildung der Metallkeime wird jedoch verbessert, wenn die Folie als Füllstoff Siliciumdioxid in den oben genannten Maximalmengen und Teilchengrößen enthält. Für die Bildung der Metallkeime hat es sich als besonders günstig erwiesen, wenn die Folie 0,1 - 20,0 Gew.-%, bevorzugt 0,5 - 15,0 Gew.-% und besonders bevorzugt 1,0 - 5,0 Gew.-% Siliciumdioxid-Partikel mit einem $d_{50}$ < 1 µm enthält.

Die erfindungsgemäße Folie kann weitere Additive wie UV-Stabilisatoren, Flammschutzmittel, Hydrolysestabilisatoren und Antioxidantien enthalten.

In einer weiteren Ausführungsform ist die erfindungsgemäße Folie flammhemmend ausgerüstet. Flammhemmend bedeutet, dass die Folie in einer sogenannten Brandschutzprüfung gemäß UL94 VTM mindestens die Klasse VTM-2 erreichen. Die Folie enthält dann ein Flammschutzmittel in einer Konzentration im Bereich von 0,2 bis 30 Gew.-%, bevorzugt 0,5 bis 25 Gew.-%, besonders bevorzugt von 1,0 bis 20 Gew.-%, bezogen auf das Gewicht der Folie. Wesentlich ist, dass das Flammschutzmittel im Polyester löslich ist, da andernfalls die geforderten mechanischen Eigenschaften nicht erreicht werden. Geeignete Flammschutzmittel sind beispielsweise organische Brom-, Chlor- oder Stickstoffverbindungen oder Metallhydroxide oder -trihydrate. Die Halogenverbindungen haben allerdings den Nachteil, dass im Brandfall toxische und korrosiv wirkende Halogenwasserstoffe entstehen. Nachteilig ist auch die geringe Lichtbeständigkeit einer damit ausgerüsteten Folie. Weitere geeignete Flammschutzmittel sind beispielsweise organische Phosphorverbindungen wie Carboxyphosphinsäuren, deren Anhydride und Methanphosphonsäuredimethylester. Sehr geeignet sind hierbei Flammschutzmittel, bei denen die Phosphorverbindung chemisch an den Polyester gebunden ist. Ganz besonders bevorzugt ist [(6-oxido-6H-dibenz[c,e][1,2]oxaphosphorin-6-yl)methyl]butandicarbonsäure-bis-(2-hydroxyethyl)ester mit der Formel

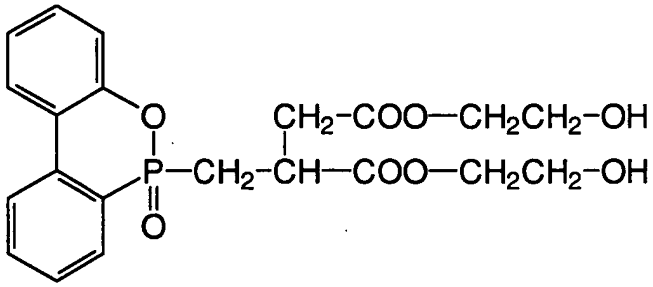

In dieser bevorzugten Ausführungsform enthält die erfindungsgemäße schwer entflammbare Folie neben dem Polyester, der strahlungsaktivierbaren Verbindung und gegebenenfalls partikulären Additiven 1 bis 20 Gew.-% einer im Polyester löslichen organischen Phosphorverbindung als Flammschutzmittel.

Da die Flammschutzmittel im allgemeinen eine gewisse Hydrolyseempfindlichkeit aufweisen, kann der zusätzliche Einsatz eines Hydrolysestabilisators sinnvoll sein. Geeignete Hydrolysestabilisatoren sind beispielsweise polymere Carbodiimide wie z.B. ®Stabaxol P von Fa. Rheinchemie (DE). Diese werden bevorzugt in einer Menge von 0,1 bis 1,0 Gew.-% (bezogen auf die Masse der Folie) eingesetzt.

Diese oben genannten Anteile an Flammschutzmittel und Hydrolysestabilisator haben sich auch dann als günstig erwiesen, wenn der Hauptbestandteil der Folie nicht Polyethylenterephthalat, sondern ein anderer Polyester ist.

Die strahlungsaktivierbare Verbindung und die ggf. verwendeten weiteren Additive wie Partikel, UV-Stabilisatoren, Flammschutzmittel, Hydrolysestabilisatoren und Antioxidantien können dem zur Herstellung der erfindungsgemäßen Folie verwendeten Polyester als glykolische Dispersion während der Polykondensation zugegeben werden. Bevorzugt ist jedoch die Zugabe der strahlungsaktivierbaren Komponente und/oder der ggf. verwendeten weiteren Additive über Masterbatche zum Polyesterrohstoff während der Folienextrusion.

Ebenso kann die Folie zur Einstellung weiterer Eigenschaften beschichtet werden. Typische Beschichtungen sind insbesondere haftvermittelnd, antistatisch, schlupfverbessernd oder dehäsiv wirkende Schichten. Es bietet sich an, diese zusätzlichen Schichten über in-line coating mittels wässriger Dispersionen nach der Längs- und vor der Querstreckung auf die Folie aufzubringen.

In einer besonderen Ausführungsform weist die Folie mindestens einseitig eine Silikonbeschichtung auf wie sie z.B. in der US-A-5,728,339 beschrieben ist. Diese Ausführungsform hat den Vorteil, dass nach der Laserbehandlung die umliegenden Bereiche vor der korrodierenden Wirkung des galvanischen Bades geschützt sind und sich Reste der Galvaniklösung leichter von der Folienoberfläche entfernen lassen.

Für bestimmte Anwendungen kann es zweckmäßig sein, die Oberfläche der Folie mit einer Säure chemisch vorzubehandeln. Für diese sogenannte Ätzhaftvermittlung eignen sich insbesondere Trichloressigsäure, Dichloressigsäure oder Flusssäure, die für eine kurze Zeit (zwischen 5 und 120 Sekunden) auf die Oberfläche einwirken und dann mittels Luftmesser wieder entfernt werden. Dadurch erhält die Folie eine sehr reaktive, amorphe Oberfläche.

Die Additive, also die strahlungsaktivierbare Metallverbindung sowie die gegebenenfalls vorhandenen weiteren Füllstoffe und sonstigen Additive, können mittels eines handelsüblichen Zweischneckenextruders (z.B. von Coperion) in das Polymer eingebracht werden. Dabei wird ein erfindungsgemäßes Polyestergranulat zusammen mit den Partikel/Additiven in den Extruder eingebracht und extrudiert, anschließend in einem Wasserbad abgeschreckt und dann granuliert.

in einem bevorzugten Verfahren zur Herstellung der erfindungsgemäßen Polyester werden die Additive aber direkt bei der Polyesterherstellung zugegeben. Üblicherweise werden die Additive im Falle des DMT-Verfahrens nach der Umesterung bzw. direkt vor der Polykondensation (z.B. über die Transportleitung zwischen Umesterungs- und Polykondensationskessel) als glykolische Dispersion zugegeben. Die Zugabe kann aber auch schon vor der Umesterung erfolgen. Im Falle des TPA-Verfahrens erfolgt die Zugabe bevorzugt zu Beginn der Polykondensation. Eine spätere Zugabe ist jedoch auch möglich. Es hat sich bei diesem Verfahren als günstig erwiesen, wenn die glykolischen Dispersionen vor der Zugabe über einen PROGAF PGF 57 (Hayward Ind. USA)-Filter filtriert werden.

Gegenstand der vorliegenden Erfindung ist auch ein Verfahren zur Herstellung der Folie. Allgemein erfolgt die Herstellung durch ein Extrusionsverfahren, beispielsweise auf einer Extrusionsstrasse. Als besonders vorteilhaft hat es sich erwiesen, die strahlungsaktivierbare Komponente und die ggf. verwendeten weiteren Additive wie Partikel, UV-Stabilisatoren, Flammschutzmittel, Hydrolysestabilisatoren und Antioxidantien in Form von vorgetrockneten oder vorkristallisierten Masterbatchen vor der Extrusion zuzugeben.

Bevorzugt bei der Masterbatchtechnologie ist, dass die Korngröße und das Schüttgewicht der Masterbatche ähnlich der Korngröße und dem Schüttgewicht des verwendeten Polyesterrohstoffs ist, so dass eine homogene Verteilung erreicht wird, aus der homogene Eigenschaften resultieren.

Die Polyesterfolien können nach bekannten Verfahren aus einem Polyesterrohstoff, und gegebenenfalls weiteren Rohstoffen, mindestens einer strahlungsaktivierbaren Komponente sowie gegebenenfalls weiteren Additiven als einschichtige Folie (Monofolie) hergestellt werden.

Masterbatche, die die strahlungsaktivierbare Komponente enthalten, sind bevorzugt vorkristallisiert und/oder vorgetrocknet. Das gleiche gilt für Masterbatche, die Partikel, UV-Stabilisator(en), Flammschutzmittel und/oder andere Additive enthalten. Die Vortrocknung beinhaltet ein graduelles Erhitzen der Masterbatche unter reduziertem Druck (20 bis 80 mbar, vorzugsweise 30 bis 60 mbar, insbesondere 40 bis 50 mbar) sowie Rühren und gegebenenfalls ein Nachtrocknen bei konstanter, erhöhter Temperatur (ebenfalls unter reduziertem Druck). Die Masterbatche werden vorzugsweise bei Raumtemperatur aus einem Dosierbehälter in der gewünschten Abmischung zusammen mit dem Polyesterrohstoff und gegebenenfalls anderen Rohstoffkomponenten chargenweise in einen Vakuumtrockner, der im Laufe der Trocken- bzw. Verweilzeit ein Temperaturspektrum von 10 bis 160°C, vorzugsweise 20 bis 150 °C, insbesondere 30 bis 130 °C, durchläuft, gefüllt. Während der etwa 6-stündigen, vorzugsweise 5-stündigen, insbesondere 4-stündigen Verweilzeit wird die Rohstoffmischung mit 10 bis 70 Upm, vorzugsweise 15 bis 65 Upm, insbesondere 20 bis 60 Upm, gerührt. Das so vorkristallisierte bzw. vorgetrocknete Rohstoffgemisch wird in einem nachgeschalteten ebenfalls evakuierten Behälter bei 90 bis 180 °C, vorzugsweise 100 bis 170 °C, insbesondere 110 bis 160 °C, für 2 bis 8 Stunden, vorzugsweise 3 bis 7 Stunden, insbesondere 4 bis 6 Stunden, nachgetrocknet.

Bei dem bevorzugtem Extrusionsverfahren zur Herstellung der Folie wird das aufgeschmolzene Polymermaterial mit den Additiven durch eine Schlitzdüse extrudiert und als weitgehend amorphe Vorfolie auf einer Kühlwalze abgeschreckt. Diese Folie wird anschließend erneut erhitzt und in mindestens einer Richtung - entweder in Maschinenrichtung (MD) oder in Querrichtung (TD) - bevorzugt aber in Längs- und Querrichtung bzw. in Quer- und Längsrichtung bzw. in Längs-, in Quer- und nochmals und Längsrichtung und/oder Querrichtung verstreckt ("orientiert"). Die Folientemperaturen im Streckprozess liegen im allgemeinen 10 bis 60 °C über der Glasübergangstemperatur Tg des verwendeten Polyesters, das Streckverhältnis der Längsstreckung liegt üblicherweise bei 2,0 bis 6,0, insbesondere

bei 3,0 bis 4,5, das der Querstreckung bei 2,0 bis 5,0, insbesondere bei 3,0 bis 4,5, und das der gegebenenfalls durchgeführten zweiten Längs- und Querstreckung bei 1,1 bis 5,0. Die Längsstreckung kann auch gleichzeitig mit der Querstreckung (Simultanstreckung) oder in jeder denkbaren Sequenzfolge durchgeführt werden. Es folgt die Thermofixierung der Folie bei Ofentemperaturen von 180 bis 260 °C, insbesondere von 220 bis 250 °C. Anschließend wird die Folie abgekühlt und gewickelt.

In einer bevorzugten Ausführungsform findet die Thermofixierung zwischen 220 bis 250 °C statt, und die Folie wird bei dieser Temperatur um mindestens 1 % (bevorzugt mindestens 2 %) in Querrichtung relaxiert.

In einer weiteren bevorzugten Ausführungsform findet die Thermofixierung zwischen 220 bis 250 °C statt, und die Folie wird bei dieser Temperatur um mindestens 1 % (bevorzugt mindestens 2 %) in Querrichtung relaxiert und anschließend nochmals bei Temperaturen zwischen 180 und 150 °C in der Abkühlphase um wiederum mindestens 1 % (bevorzugt mindestens 2 %) in Querrichtung relaxiert.

In einer weiteren bevorzugten Ausführungsform wird die Folie mindestens um den Faktor 3,0 in MD und TD Richtung gestreckt, wobei die Streckung in einem Simultanrahmen stattfindet. Die Thermofixierung findet zwischen 220 bis 250 °C statt, und die Folie wird bei dieser Temperatur um mindestens 1 % in Längs und Querrichtung relaxiert.

Die erfindungsgemäßen Folien weisen die geforderten guten mechanischen Eigenschaften auf. So beträgt der E-Modul in mindestens einer Folienrichtung (Längsrichtung (MD) und/oder Querrichtung (TD)) mindestens 500 N/$mm^2$, bevorzugt mindestens 2000 N/$mm^2$ und besonders bevorzugt mindestens 4000 N/$mm^2$. Die Reißfestigkeitswerte in mindestens einer Folienrichtung (Längsrichtung (MD) und/oder Querrichtung (TD)) sind größer als 50 N/$mm^2$, bevorzugt größer als 100 N/$mm^2$ und besonders bevorzugt größer als 150 N/$mm^2$. Die Reißdehnungswerte in mindestens einer Folienrichtung (Längsrichtung (MD) und/oder Querrichtung (TD)) sind größer als 10 %, bevorzugt größer als 40 % und besonders bevorzugt größer als 80 %.

Die erfindungsgemäße Folie weist in keiner Folienrichtung (weder in MD noch in TD) einen Schrumpf bei 200 °C von größer 25 % auf. Der Schrumpf bei 200 °C ist sogar kleiner als 15 % und bevorzugt kleiner als 5 %.

Es war mehr als überraschend, dass durch den Einsatz der beschriebenen Additive, kombiniert mit der beschriebenen Vortrocknung und/oder Vorkristallisation der Rohstoffe und den beschriebenen Verfahrensbedingungen eine durch elektromagnetische Strahlung aktivierbare Folie mit dem geforderten Eigenschaftsprofil ohne technische Probleme (wie Verklebungen im Trockner oder Abrisse) herstellbar ist. Es wurden bei der Herstellung kaum oder keine Ablagerungen an den Düsen oder Ausgasungen beobachtet, wodurch die erfindungsgemäße Folie ausgezeichnete mechanische Eigenschaften, eine exzellente Optik, ein ausgezeichnetes Profil und eine ausgezeichnete Planlage aufweist. Sie lässt sich hervorragend verstrecken, so dass sie verfahrenssicher und wirtschaftlich rentabel hergestellt werden kann.

Des weiteren ist es sehr überraschend, dass auch das Rezyklat wieder einsetzbar ist, ohne die mechanischen Eigenschaften der Folie negativ zu beeinflussen. Auch im Vergleich zu einer nicht ausgerüsteten Folie sind die mechanischen Eigenschaften im Rahmen der Meßgenauigkeit nicht negativ verändert.

Durch die Kombination ihrer Eigenschaften eignen sich die erfindungsgemäßen Folien für eine Vielzahl verschiedener Anwendungen, beispielsweise für Leiterplatten, Flachbandkabel, Smartcards, RFID-Labels, Folientastaturen und folienbasierte Schaltungen aller Art.

Die Erfindung wird im Folgenden anhand von Ausführungsbeispielen näher erläutert, ohne darauf beschränkt zu sein.

Die Messung der einzelnen Eigenschaften erfolgte dabei gemäß den folgenden Normen bzw. Verfahren:

**Messmethoden**

**Mechanische Eigenschaften**

Der E-Modul, die Reißfestigkeit, Reißdehnung und der F5-Wert werden in Längs- und Querrichtung nach ISO 527-1-2 mit Hilfe eines Zug-Dehnungsmessgerät (Fa. Zwick, Typ 010, Ulm, DE) gemessen.

Schrumpf

Der thermische Schrumpf wurde an quadratischen Folienmustern mit einer Kantenlänge von 10 cm bestimmt. Die Proben werden genau ausgemessen (Kantenlänge $L_0$) und werden 15 Minuten bei 200 °C in einem Umlufttrokkenschrank getempert. Die Proben werden entnommen und bei Raumtemperatur genau ausgemessen (Kantenlänge L). Der Schrumpf ergibt sich aus der Gleichung

$$\text{Schrumpf [\%]} = 100 \cdot (L_0 - L) / L$$

**Standardviskosität (SV) und intrinsische Viskosität (IV)**

Die Standardviskosität SV wurde - angelehnt an DIN 53726 - als 1 %ige Lösung in Dichloressigsäure (DCE) bei 25 °C gemessen. SV (DCE) = (ηrel -1) x 1000. Die intrinsische Viskosität (IV) berechnet sich wie folgt aus der Standardviskosität (SV)

$$IV = [\eta] = 6.907 \cdot 10^{-4}\ SV\ (DCE) + 0{,}063096\ [dl/g]$$

**Messung des mittleren Durchmessers $d_{50}$**

Die Bestimmung des mittleren Durchmessers $d_{50}$ wurde mittels Laser auf einem Malvern Master Sizer nach der Standardmethode durchgeführt (andere Messgeräte sind z.B. Horiba LA 500 oder Sympathec Helos, welche das gleiche Messprinzip verwenden). Die Proben wurden dazu in eine Küvette mit Wasser gegeben und diese dann in das Messgerät gestellt. Der Messvorgang ist automatisch und beinhaltet auch die mathematische Bestimmung des $d_{50}$-Wertes. Der $d_{50}$-Wert wird dabei definitionsgemäß aus der (relativen) Summenkurve der Partikelgrößenverteilung bestimmt: Der Schnittpunkt des 50%-Ordinatenwertes mit der Summenkurve liefert auf der Abszissenachse sofort den gewünschten $d_{50}$-Wert. Wie dies zu verstehen ist wird in der nachstehenden Abbildung näher verdeutlicht.

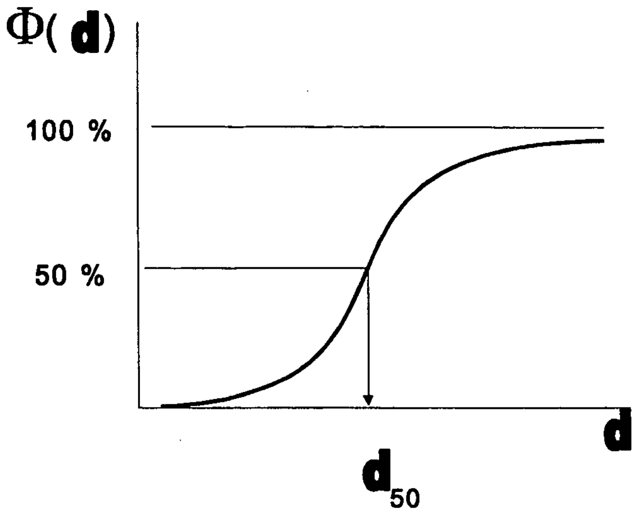


**Folienherstellung**

Polyester-Chips wurden gemäß den in den Beispielen angegebenen Verhältnissen gemischt und in einem Wirbelschichttrockner bei 155 °C für 1 Minute vorkristallisiert, anschließend für 3 Stunden in einem Schachttrockner bei 150 °C getrocknet und bei 290 °C in einem Einschneckenextruder aufgeschmolzen. Das geschmolzene Polymer wurde durch eine Breitschlitzdüse gedrückt und über eine Abzugswalze (Temperatur der Walze 20 °C) abgezogen. Der Film wurde um den Faktor 3,5 in Maschinenrichtung bei 116 °C (Folientemperatur im Streckspalt) gestreckt und in einem Rahmen bei 110 °C eine Querstreckung um den Faktor 3,2 durchgeführt. Anschließend wurde die Folie bei 229 °C thermofixiert und in Querrichtung um 1 % bei Temperaturen von 229 - 200 °C und ein weiteres mal um 1 % bei Temperaturen zwischen 180 und 150 °C relaxiert. Die Produktionsgeschwindigkeit (Endfoliengeschwindigkeit) beträgt 300 m/min.
Die Endfoliendicke beträgt 75 µm.

**Beispiele**

In den Beispielen kommen die folgenden Rohstoffe zum Einsatz:

**Masterbatch MB1:**
10 Gew.-% PK3095 der Firma Ferro und 90 Gew.-% Polyethylenterephtalat (PET)

**Masterbatch MB2:**
10 Gew.-% PK3095 der Firma Ferro und 90 Gew.-% Polybutylenterephtalat (PBT)

**Masterbatch MB3:**
4 Gew.-% $SiO^2$-Partikel Aerosil TT600 der Firma Degussa (Deutschland) ($d_{50}$ der Agglomerate ca. 300 nm; Primärteilchen $d_{50}$ ca. 50 nm) und 96 Gew.-% Polyethylenterephtalat (PET)

**Masterbatch MB4:**
4 Gew.-% $SiO_2$-Partikel Aerosil TT600 der Firma Degussa (Deutschland) ($d_{50}$ der Agglomerate ca. 300 nm; Primärteilchen $d_{50}$ ca. 50 nm) und 96 Gew.-% Polybutylenterephtalat (PBT)

**Masterbatch MB5:**
4 Gew.-% $CaCO_3$-Partikel Omyacarb BP der Firma Omya (USA) ($d_{50}$ der Partikel 22 µm) und 96 Gew.-% Polyethylenterephtalat (PET)

**Masterbatch MB6:**
10 Gew.-% PK3095 der Firma Ferro und 90 Gew.-% Polyethylennaphtalat (PEN)

**Masterbatch MB7:**
4 Gew.-% $SiO_2$ Partikel Aerosil TT600 der Firma Degussa (Deutschland) ($d_{50}$ der Agglomerate ca. 300 nm; Primärteilchen $d_{50}$ ca. 50 nm) und 96 Gew.-% Polyethylennaphtalat (PEN)

**Masterbatch MBB:**
4 Gew.-% $CaCO_3$-Partikel Hydrocarb 70 mit einem $d_{50}$-Wert von 1,6 µm (Fa. Omya) (Deutschland) und 96 Gew.-% Polyethylenterephtalat (PET)

**Masterbatch MB9:**
Das Masterbatch MB9 enthält 6 Gew.-% M-Ester der Firma Sanko Co. Ltd. (Cas Nr. 63562-34-5) und 94 Gew.-% Polyethylenterephthalat der Firma KoSa.

**Rohstoff R1:**
100 Gew.-% Polyethylenterephthalat RT49 der Firma Kosa (Deutschland)

**Rohstoff R2:**
25 Gew.-% Aerosil 90 der Firma Degussa (Deutschland), 5 Gew.-% PK3095 der Firma Ferro und 70 Gew.-% Polybutylenterephtalat (PBT)

**Rohstoff R3:**
100 Gew.-% Polybutylenterephthalat

**Rohstoff R4:**
100 Gew.-% Polyethylennaphthalat

**Beispiel 1**

50 Gew.-% MB1 werden mit 25 Gew.-% MB3 und 25 Gew.-% R1 gemischt und wie oben angegeben zu einer 75 µm Folie weiterverarbeitet. Die Eigenschaften können der Tabelle 1 entnommen werden.

**Beispiel 2**

Beispiel 1 wurde wiederholt, wobei zusätzlich 50 Gew.-% Rezyklat, hergestellt aus der Folie aus Beispiel 1, eingesetzt wurde. Die Eigenschaften können der Tabelle 1 entnommen werden.

**Beispiel 3**

50 Gew.-% MB1 wurden mit 50 Gew.-% R1 gemischt und wie oben angegeben zu einer 75 µm Folie weiterverarbeitet. Die Eigenschaften können der Tabelle 1 entnommen werden.

**Beispiel 4**

60 Gew.-% MB1 wurden mit 40 Gew.-% MB8 gemischt und wie oben angegeben zu einer 75 µm Folie weiterverarbeitet. Die Eigenschaften können der Tabelle 1 entnommen werden.

**Beispiel 5**

50 Gew.-% MB6 wurden mit 25 Gew.-% MB7 und 25 Gew.-% R4 gemischt und wie oben angegeben zu einer 75 µm Folie weiterverarbeitet. Die Eigenschaften können der Tabelle 1 entnommen werden.

**Beispiel 6**

50 Gew.-% MB1 wurden mit 40 Gew.-% MB3 und 10 Gew.-% R3 gemischt und wie oben angegeben zu einer 75 µm Folie weiterverarbeitet. Die Eigenschaften können der Tabelle 1 entnommen werden.

**Beispiel 7**

50 Gew.-% MB1 wurden mit 25 Gew.-% MB3 und 25 Gew.-% MB9 gemischt und wie oben angegeben zu einer 75 µm Folie weiterverarbeitet. Die Folie wurde einem Brandtest gemäß UL94 VTM unterzogen und erreichte die Brandklasse VTM-0. Die sonstigen Eigenschaften können der Tabelle 1 entnommen werden.

**Vergleichsbeispiel 1**

Es wurde versucht wie oben angegeben aus dem Rohstoff R2 (angelehnt an den Rohstoff aus dem Beispiel aus EP-A-1 274 288) eine 75 µm Folie herzustellen. Die Verstreckung der Folie erwies sich als unmöglich, da jeder Streckversuch zu Abrissen führte. Es konnte keine Folie hergestellt werden.

**Vergleichsbeispiel 2**

60 Gew.-% MB1 wurden mit 40 Gew.-% MB5 gemischt und wie oben angegeben zu einer 75 µm Folie weiterverarbeitet. Es konnten nur kleine Mengen erzeugt werden, da es bei der Herstellung häufig zu Abrissen bei der Streckung kam. Eine wirtschaftliche Herstellung der Folie ist nicht möglich. Die Eigenschaften können der Tabelle 1 entnommen werden.

**Vergleichsbeispiel 3**

50 Gew.-% MB1 wurden mit 25 Gew.-% MB3 und 25 Gew.-% R1 gemischt und wie oben angegeben zu einer 75 µm Folie weiterverarbeitet. Die Thermofixierung erfolgte jedoch nicht wie oben beschrieben bei 229 °C, sondern bei 150 °C, und es erfolgte keine Relaxation. Die Eigenschaften können der Tabelle 1 entnommen werden.

**Leiterbahnerzeugung:**

Die hergestellten Folien werden im Bereich der aufzubringenden Leiterbahnen einer Laserstrahlung, die von einem diodengepumpten Nd:YAG-Laser erzeugt wird (hier Microline 3D IR 160 der Firma LPKF AG (Deutschland)), mit einer Intensität bestrahlt, die einen geringfügigen Abtrag erzeugt, der mit einer strukturierten Bekeimung verbunden ist. Nach kurzer Behandlung in einem demineralisiertes Wasser enthaltenden Ultraschall-Reinigungsbad wird die Folie durch ein handelsübliches chemisch reduktives Verkupferungsbad geführt. Hier werden in den bestrahlten Bereichen die Leiterbahnen aufgebaut.

**Ergebnisse der Leiterbahnerzeugung:**

Die erzeugten Leiterbahnen wurden mittels eines Lichtmikroskops (Auflicht) bei 20-facher Vergrößerung visuell beurteilt. Die Geschlossenheit der Kupferschicht wurde visuell bewertet und in die folgenden Kategorien eingeteilt: gut, weniger gut und schlecht.

**Tabelle 1**

| Beispiel | E-Modul MD in N/mm² | E-Modul TD in N/mm² | Reißfestigkeit MD in N/mm² | Reißfestigkeit TD in N/mm² | Reißdehnung MD in % | Reißdehnung TD in % | Schrumpf MD 200 °C | Schrumpf TD 200 °C | Leiterbahn-erzeugung |
|---|---|---|---|---|---|---|---|---|---|
| 1 | 4100 | 5800 | 185 | 290 | 168 | 100 | 4,5 | 1,9 | gut |
| 2 | 4000 | 5700 | 184 | 291 | 170 | 105 | 4,4 | 2,0 | gut |
| 3 | 4000 | 5400 | 170 | 281 | 162 | 98 | 4,4 | 2 | weniger gut |
| 4 | 4200 | 5500 | 175 | 285 | 165 | 95 | 4,4 | 2 | gut |
| 5 | 4300 | 6100 | 176 | 300 | 155 | 90 | 4,7 | 2,3 | gut |
| 6 | 3900 | 5000 | 165 | 210 | 172 | 110 | 3,5 | 1 | gut |
| 7 | 4000 | 5200 | 172 | 230 | 170 | 115 | 5,5 | 3 | gut |
| Vergleichsbeispiel | | | | | | | | | |
| 1 | keine Folie erhalten | keine Folie erhalten | keine Folie erhalten | keine Folie erhalten | keine Folie erhalten | keine Folie erhalten | keine Folie erhalten | keine Folie erhalten | keine Folie erhalten |
| 2 | 4000 | 5500 | 50 | 25 | 15 | 5 | 4,5 | 2 | schlecht |
| 3 | 4200 | 5900 | 190 | 298 | 200 | 110 | 22 | 28 | gut*) |

*) Nach Laserbestrahlung bildeten sich Falten

## Patentansprüche

1. Einschichtige, mindestens monoaxial orientierte Polyesterfolie mit einer Gesamtdicke von 5 - 500 µm, **dadurch gekennzeichnet, dass** sie eine Metallverbindung enthält, die bei Bestrahlung mit elektromagnetischer Strahlung in dem Polyester Metall in elementarer Form freisetzt.

2. Polyesterfolie nach Anspruch 1, **dadurch gekennzeichnet, dass** die Metallverbindung ein Metalloxid ist.

3. Polyesterfolie nach Anspruch 1 oder 2, **dadurch gekennzeichnet, dass** die Metallverbindung ein Spinell ist.

4. Polyesterfolie nach einem der Ansprüche 1 bis 3, **dadurch gekennzeichnet, dass** die Metallverbindung $CuCr_2O_4$ ist.

5. Polyesterfolie nach einem der Ansprüche 1 bis 4, **dadurch gekennzeichnet, dass** die Metallverbindung in der Folie in einer Menge von 0,1 bis 15,0 Gew.-% enthalten ist.

6. Polyesterfolie nach einem der Ansprüche 1 bis 5, **dadurch gekennzeichnet, dass** sie partikuläre Additive enthält.

7. Polyesterfolie nach einem der Ansprüche 1 bis 6, **dadurch gekennzeichnet, dass** sie ein Flammschutzmittel enthält.

8. Polyesterfolie nach einem der Ansprüche 1 bis 7, **dadurch gekennzeichnet, dass** sie einen Hydrolysestabilisator enthält.

9. Polyesterfolie nach einem der Ansprüche 1 bis 8, **dadurch gekennzeichnet, dass** sie auf mindestens einer Oberfläche eine Silikonbeschichtung aufweist.

10. Polyesterfolie nach einem der Ansprüche 1 bis 9, **dadurch gekennzeichnet, dass** sie aus einem Polyester aufgebaut ist, der als Dicarbonsäurekomponente 10 bis 100 Mol-% Terephthalat enthält (bezogen auf die Gesamtmenge der vorhandenen Dicarbonsäurekomponenten).

11. Polyesterfolie nach einem der Ansprüche 1 bis 9, **dadurch gekennzeichnet, dass** sie aus einem Polyester aufgebaut ist, der als Dicarbonsäurekomponente 10 bis 100 Mol-% 2,6-Naphthalat enthält (bezogen auf die Gesamtmenge der vorhandenen Dicarbonsäurekomponenten).

12. Polyesterfolie nach einem der Ansprüche 1 bis 11, **dadurch gekennzeichnet, dass** sie einen E-Modul in mindestens einer Folienrichtung (Längsrichtung (MD) und/oder Querrichtung (TD)) von größer als 500 $N/mm^2$ aufweist.

13. Polyesterfolie nach einem der Ansprüche 1 bis 12, **dadurch gekennzeichnet, dass** sie Reißfestigkeitswerte in mindestens einer Folienrichtung (Längsrichtung (MD) und/oder Querrichtung (TD)) von größer als 50 $N/mm^2$ aufweist.

14. Polyesterfolie nach einem der Ansprüche 1 bis 13, **dadurch gekennzeichnet, dass** sie Reißdehnungswerte in mindestens einer Folienrichtung (Längsrichtung (MD) und/oder Querrichtung (TD)) von größer als 10 % aufweist.

15. Polyesterfolie nach einem der Ansprüche 1 bis 14, **dadurch gekennzeichnet, dass** sie in keiner Folienrichtung (weder in MD noch in TD) einen Schrumpf bei 200 °C von größer 25 % aufweist.

16. Verfahren zur Herstellung einer Polyesterfolie nach Anspruch 1, **dadurch gekennzeichnet, dass** man einen Polyesterrohstoff und eine Metallverbindung, die bei Bestrahlung mit elektromagnetischer Strahlung in dem Polyester Metall in elementarer Form freisetzt, zusammen durch eine Schlitzdüse extrudiert, abkühlt, erneut erhitzt und anschließend mindestens in einer Richtung orientiert und dann thermofixiert.

17. Verwendung einer Folie nach Anspruch 1 in Leiterplatten, Flachbandkabeln, Smartcards, RFID-Labels, Folientastaturen und folienbasierten Schaltungen.

18. Verwendung einer Metallverbindung, die bei Bestrahlung mit elektromagnetischer Strahlung Metall in elementarer Form freisetzt zur Herstellung von Folien.

**19.** Verwendung einer Metallverbindung, die bei Bestrahlung mit elektromagnetischer Strahlung Metall in elementarer Form freisetzt zur Herstellung von Leiterplatten, Flachbandkabeln, Smartcards, RFID-Labels, Folientastaturen und folienbasierten Schaltungen.

Europäisches Patentamt

# EUROPÄISCHER RECHERCHENBERICHT

Nummer der Anmeldung
EP 04 02 2020

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| X | US 5 470 637 A (SAKAMOTO JUN ET AL) 28. November 1995 (1995-11-28) * Spalte 4, Zeilen 47-51; Anspruch 1 * | 1,5 | C08J5/18<br>C08K3/22<br>C08L67/02<br>C23C18/16<br>H05K3/18 |
| X | PATENT ABSTRACTS OF JAPAN Bd. 1995, Nr. 09, 31. Oktober 1995 (1995-10-31) & JP 7 166034 A (TEIJIN LTD), 27. Juni 1995 (1995-06-27) * Zusammenfassung * | 1,5 | |
| A | DE 197 23 734 A (NAUNDORF GERHARD PROF DR ; WISBROCK HORST PROF DR (DE)) 10. Dezember 1998 (1998-12-10) * Ansprüche 1-16 * | 1 | |
| A,D | EP 1 274 288 A (LPKF LASER & ELECTRONICS AG) 8. Januar 2003 (2003-01-08) * Absatz [0022]; Ansprüche 1-15 * | 1-19 | |
| | | | RECHERCHIERTE SACHGEBIETE (Int.Cl.7) |
| | | | C08J<br>C08K<br>C08L<br>C23C<br>H05K |

Der vorliegende Recherchenbericht wurde für alle Patentansprüche erstellt

1

| Recherchenort | Abschlußdatum der Recherche | Prüfer |
|---|---|---|
| München | 24. November 2004 | Hoffmann, K |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)

## ANHANG ZUM EUROPÄISCHEN RECHERCHENBERICHT ÜBER DIE EUROPÄISCHE PATENTANMELDUNG NR. EP 04 02 2020

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

24-11-2004

| Im Recherchenbericht angeführtes Patentdokument | | Datum der Veröffentlichung | Mitglied(er) der Patentfamilie | | | Datum der Veröffentlichung |
|---|---|---|---|---|---|---|
| US 5470637 | A | 28-11-1995 | JP | 5156140 | A | 22-06-1993 |
| | | | JP | 5163371 | A | 29-06-1993 |
| | | | JP | 3543972 | B2 | 21-07-2004 |
| | | | JP | 5171012 | A | 09-07-1993 |
| | | | JP | 3136718 | B2 | 19-02-2001 |
| | | | JP | 5171017 | A | 09-07-1993 |
| | | | JP | 5318579 | A | 03-12-1993 |
| | | | CA | 2103557 | A1 | 10-06-1993 |
| | | | DE | 69220932 | D1 | 21-08-1997 |
| | | | EP | 0577838 | A1 | 12-01-1994 |
| | | | HK | 1001591 | A1 | 26-06-1998 |
| | | | WO | 9312177 | A1 | 24-06-1993 |
| | | | KR | 255141 | B1 | 01-05-2000 |
| JP 7166034 | A | 27-06-1995 | KEINE | | | |
| DE 19723734 | A | 10-12-1998 | DE | 19723734 | A1 | 10-12-1998 |
| | | | AT | 231195 | T | 15-02-2003 |
| | | | CN | 1272892 | T | 08-11-2000 |
| | | | DE | 19731346 | A1 | 04-03-1999 |
| | | | DE | 59806926 | D1 | 20-02-2003 |
| | | | WO | 9855669 | A2 | 10-12-1998 |
| | | | EP | 0917597 | A2 | 26-05-1999 |
| | | | JP | 2000502407 | T | 29-02-2000 |
| | | | US | 6319564 | B1 | 20-11-2001 |
| EP 1274288 | A | 08-01-2003 | DE | 10132092 | A1 | 23-01-2003 |
| | | | WO | 03005784 | A2 | 16-01-2003 |
| | | | EP | 1274288 | A1 | 08-01-2003 |

EPO FORM P0461

Für nähere Einzelheiten zu diesem Anhang : siehe Amtsblatt des Europäischen Patentamts, Nr.12/82